Europäisches Patentamt

European Patent Office

Office européen des brevets

(19)

(11) Publication number: **0 107 387**
A2

(12) ## EUROPEAN PATENT APPLICATION

(21) Application number: 83305837.3

(51) Int. Cl.³: **G 11 C 11/24**

(22) Date of filing: 28.09.83

(30) Priority: 28.09.82 JP 167522/82

(43) Date of publication of application: 02.05.84
Bulletin 84/18

(84) Designated Contracting States: DE FR GB

(71) Applicant: FUJITSU LIMITED, 1015, Kamikodanaka
Nakahara-ku, Kawasaki-shi Kanagawa 211 (JP)

(72) Inventor: Takemae, Yoshihiro, Shuwa Akasaka
Hinokicho Rejidensu 303, 8-13-24, Akasaka Minato-ku
Tokyo 107 (JP)
Inventor: Nakano, Tomio, 12-404, 1-11-2, Shirahatadai,
Miyamae-ku Kawasaki-shi Kanagawa 213 (JP)
Inventor: Sato, Kimiaki, 311, 5-12-24, Minami Aoyama,
Minato-ku Tokyo 107 (JP)

(74) Representative: Sunderland, James Harry et al,
HASELTINE LAKE & CO Hazlitt House 28 Southampton
Buildings Chancery Lane, London WC2A 1AT (GB)

(54) **Semiconductor memory device.**

(57) A dynamic memory having single element storage cells
(20). One side of a plurality of gates (24, 32) are connected to both
ends of column lines (CL0 to $\overline{CL511}$) of the storage cell array. A
plurality of sense amplifiers (SA0 to SA511) are disposed along
both ends of the column lines and connected to the other side of
the gate circuits. In accordance with switching of the gate circuits,
a part of the sense amplifiers are communicated with a part of the
column lines so as to execute the refresh operation and read out
or write in operation of the communicate storage cells.
Also the remaining sense amplifiers are communicated with the
remaining column lines to execute only the refresh operation of
the storage cells coupled to the remaining column lines.

## SEMICONDUCTOR MEMORY DEVICE

The present invention relates to a dynamic memory.

A dynamic memory device of a single element type is now well-known. In such a memory, since each storage cell is composed of one FET and one capacitor, the size of each cell can be made very small. The greater the capacity of the memory, the smaller  or spacing each storage cell must be. Therefore, the pitch /of the storage cells in such a dynamic memory becomes small, making it difficult to dispose  sense amplifiers, which are  complicated and hence / relatively large, therebetween.

In a known dynamic memory device of a single element type, sense amplifiers are disposed on both sides of the storage cells array on at one pitch intervals.        In this dynamic memory, sense amplifiers for accessing adjacent column lines are alternately disposed on opposite sides of the storage cell array. According to this prior art, twice the usual pitch space is available for each of the sense amplifiers, enabling the pitch to be further narrowed. However, a column decoder with an input/output (I/O) circuit must be provided at each side of the storage cell array. These column decoders occupy a large area  device of the memory/. Furthermore, the decoders require long address lines for connection thereto, and the load of  considerable. the address lines becomes /        This makes it extremely difficult to layout the address lines and greatly decreases the access speed.

An embodiment                of the present invention can provide a semiconductor memory device which has narrow pitch of storage cells without increasing the number of the column decoders.

This can be achieved by providing /a semiconductor memory device comprising a plurality of row lines; a plurality of column lines; a plurality of storage cells coupled to one of the row lines and to one of the column lines; a plurality of gate means connected to both ends of the column lines; a plurality of sense amplifiers disposed along both ends of the column lines and connected to the gate means; and a selection circuit for switching the gate means in response to at least one selection signal, so that some of the column lines communicate via the gate means with some of the sense amplifiers to execute the read out operation and the refresh operation or write in operation of the communicated storage cells, and the remaining column lines communicate via the gate means with the remaining sense amplifiers to execute only the refresh operation of the communicated storage cells.

According to an embodiment of /the present invention, only the sense amplifiers disposed on one side of the storage cells array are used for read out or write in operations of the storage cells. Thus, two column decoders are not necessary. Only a single column decoder need be provided for the storage cell array, even though sense amplifiers are disposed on both sides of the array. Therefore, the pitch of storage cells can be narrowed without increasing the pattern area of the memory device and also without decreasing the access speed which would occur with a heavy load of the address lines.

Reference is made, by way of example, to the following drawings in which:

Figure 1 is a block diagram of a memory device of the prior art;

Fig. 2 is a block diagram of an embodiment according to the present invention;

Figs. 3a and 3b are waveform diagrams for explaining the read/write operation of the embodiment of Fig. 2;

Fig. 4 which is separately illustrated as Figs. 4a and 4b is a block diagram of another embodiment according to the present invention; and

Fig. 5 is a circuit diagram of a part of the embodiment of Fig. 4.

Before describing a memory device of the present invention, a prior art memory device will be described for reference purposes.

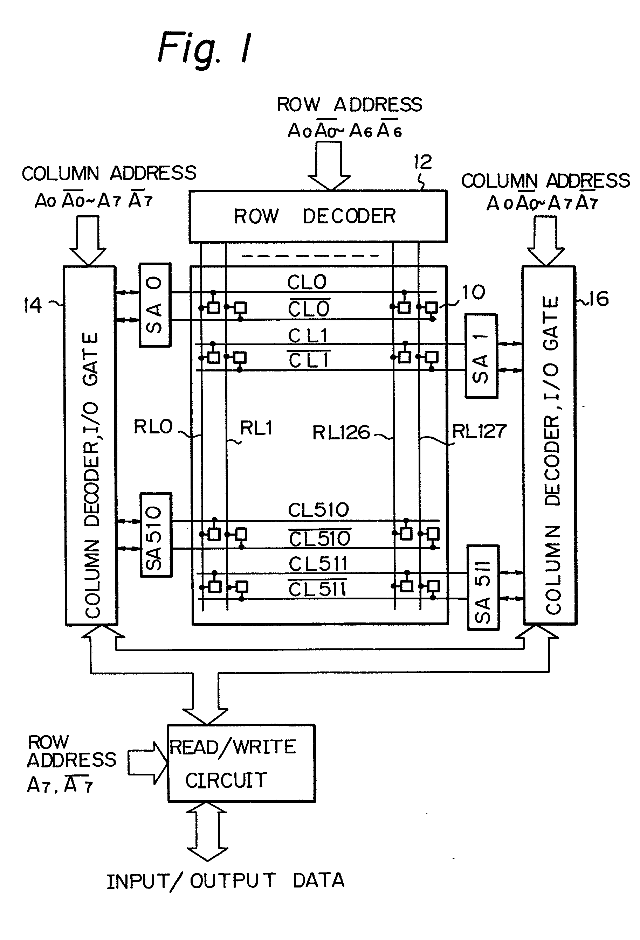

Figure 1 illustrates a dynamic memory device with a storage capacity of 64 kbits according to the prior art. In Fig. 1, reference numeral 10 indicates one of a plurality of single element type storage cells arrayed in 128 rows and 512 columns, and 12 a row decoder (word decoder) coupled to each of row lines (word lines) RL0 to RL127. Reference symbols CL0 and $\overline{CL0}$ to CL511 and $\overline{CL511}$ indicate pairs of column lines (bit lines). Sense amplifiers SA0 to SA511 are connected to each pair of the column lines. The sense amplifiers SA0, SA2, ---, and SA510 indicated by even numbers are disposed on the left side of the storage cell array in Fig. 1, and the sense amplifiers SA1, SA3, ---, and SA511 indicated by odd numbers are disposed on the right side. That is, the sense amplifiers are alternately disposed on opposite sides of the array. Therefore, twice the usual pitch space is available for each sense amplifier, enabling the pitch to be further narrowed without making disposition of the sense amplifiers difficult.

However, as mentioned before, such a memory device requires two column decoders and I/O gate circuits 14 and 16.

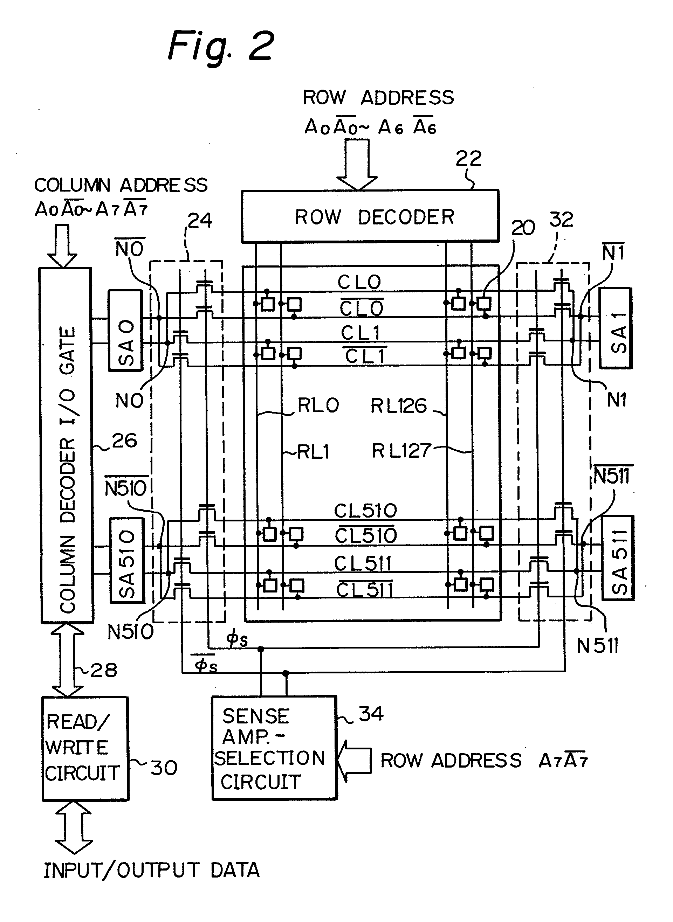

Figure 2 illustrates an embodiment of the present invention. In Fig. 2, reference numeral 20 indicates one of a plurality of single element storage cells arrayed in 128 rows and in 512 columns. Each of the metal-oxide-semiconductor field effect transistor (MOSFET) storage cells is composed of one / and a capacitor. In Fig. 2, furthermore, reference symbols RL0 to RL127 indicate row lines (word lines). CL0 and $\overline{CL0}$ to CL511 and $\overline{CL511}$ indicate pairs of column lines (bit lines) crossing the row lines RL0 to RL127. Each of the storage cells is connected to one of the row lines RL0 to RL127 and to one of the column lines CL0 to CL511 and $\overline{CL0}$ to $\overline{CL511}$ at the crossing points.

A row decoder (word decoder) 22 is coupled to the end of the row lines RL0 to RL127 and selects one of 128 row lines in accordance with an upper 7 bit address $A_0\overline{A}_0$ to $A_6\overline{A}_6$ of the row address $A_0\overline{A}_0$ to $A_7\overline{A}_7$.

One of the ends of the column lines CL0 to CL511 and $\overline{CL0}$ to $\overline{CL511}$ can be coupled to sense amplifiers indicated by even numbers SA0 SA2, ---, SA508 and SA510 via bidirectional transfer gate elements composed of FET's. Reference numeral 24 in Fig. 2 indicates a gate circuit including these gate elements. Each of the sense amplifiers SA0, SA2, ---, and SA510, which includes a bistable circuit and an active pull-up circuit, is coupled to two pairs of the column lines. For example, two pairs of the column lines CL0 and $\overline{CL0}$, CL1 and $\overline{CL1}$ are coupled to SA0, and CL2 and $\overline{CL2}$, CL3 and $\overline{CL3}$ are coupled to SA2. The sense amplifiers SA0, SA2, ---, and SA510 are also connected to a column decoder (bit decoder) and I/O gate circuit 26. The column decoder and I/O gate circuit 26 select one of 256 column lines in accordance with column address $A_0\overline{A}_0$ to $A_7\overline{A}_7$, and transfer information from the selected column lines, namely, from the selected storage cell to a read/write circuit 30 via a bus line 28. The column decoder and I/O gate circuit 26 also transfers information from the read/write circuit 30 to the selected storage cell.

The other ends of the column lines CL0 to CL511 and $\overline{CL0}$ to $\overline{CL511}$ can be coupled to sense amplifiers indicated by odd numbers SA1, SA3, ---, and SA511, via bidirectional transfer gate elements also composed of FET's.

In Fig. 2, reference numeral 32 denotes a gate circuit including these gate elements. Each of the sense amplifiers SA1, SA3, ---, and SA511, which include a bistable circuit and an active pull-up circuit, is coupled to two pairs of the column lines as well as the aforementioned sense amplifiers SA0, SA2, ---, and SA510. However, these sense amplifiers SA1, SA3, ---, and SA511 are not connected to a column decoder. Information detected by these sense amplifiers SA1, SA3, ---, and SA511 is amplified and then written back to the original storage cell without being output. In other words, these sense amplifiers SA1, SA3, ---, and SA511 are provided for refreshing the storage cells.

Each gate element (FET) in the gate circuits 24 and 32 has a control terminal (gate) connected to a sense amplifier selection circuit 34, and thus turns on or off in response to selection signals $\phi_S$ and $\bar{\phi}_S$ from the sense amplifier selection circuit 34. The sense amplifier selection circuit 34 produces the selection signals $\phi_S$ and $\bar{\phi}_S$ depending upon the least significant bit (LSB) $A_7$ and $\bar{A}_7$ of the row address.

When the selection signal $\phi_S$ is the "H" level and the other selection signal $\bar{\phi}_S$ is the "L" level, pairs of the even number column lines CL0 and $\overline{CL0}$, CL2 and $\overline{CL2}$, ---, and CL510 and $\overline{CL510}$ are communicated with the sense amplifiers SA0, SA2, ---, and SA510 indicated in the left side in Fig. 2, and pairs of the odd number column lines CL1 and $\overline{CL1}$, CL3 and $\overline{CL3}$, ---, and CL511 and $\overline{CL511}$ are communicated to the sense amplifiers SA1, SA3, ---, and SA511 indicated in the right side in Fig. 2. Therefore, in this case, information on the pairs of the even number column lines CL0 and $\overline{CL0}$, CL2 and $\overline{CL2}$, ---, and CL510 and $\overline{CL510}$ is detected by the sense amplifiers SA0, SA2, ---, and SA510 and then fed to the column decoder and I/O gate circuit 26. The column decoder and I/O gate circuit 26 selects one of the 256 column lines and obtains information on a desired column line or

- 6 -                    0107387

writes information to a storage cell on a desired column line. Meanwhile, ₃ information on the pairs of the odd number column lines CL1 and $\overline{CL1}$, CL3 and $\overline{CL3}$, ---, and CL511 and $\overline{CL511}$ is refreshed by the sense amplifiers SA1, SA3, --- and SA511.

In contrast with this, when the selection signal $\phi_S$ is the "L" level and $\overline{\phi}_S$ is the "H" level, information on the pairs of the odd number column lines CL1 and $\overline{CL1}$, CL3 and $\overline{CL3}$, ---, and CL511 and $\overline{CL511}$ is read or written.

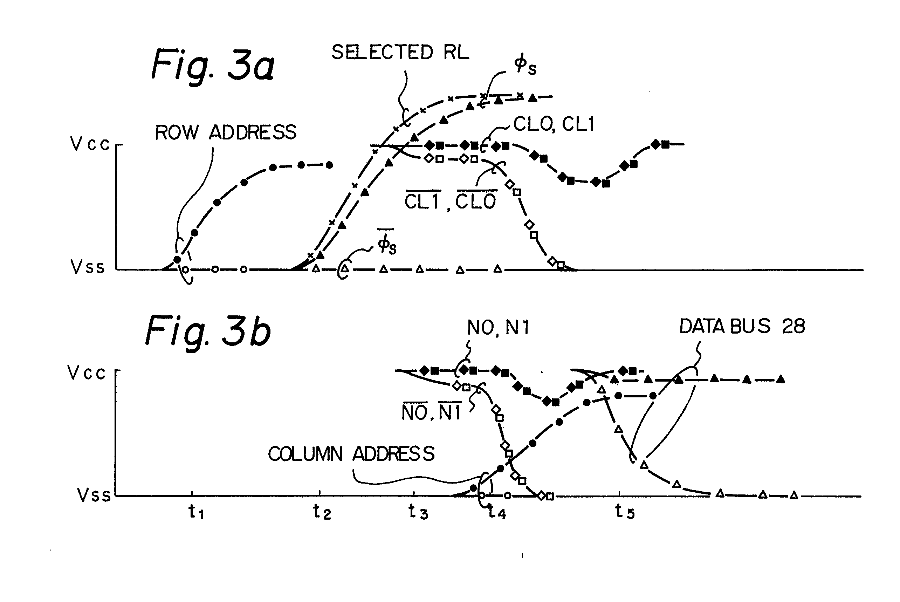

Figures 3a and 3b illustrate waveforms of various signals /present during operation of the embodiment of Fig. 2. The now read/write operation of the embodiment of Fig. 2 will/be explained.

At a time $t_1$ , the row addresses $A_0\overline{A}_0$ to $A_7\overline{A}_7$ are given. Then, at a time $t_2$ , a single row line is selected (the voltage on a selected row line RL rises) by the row decoder 22. At the same time, the selection signal $\phi_S$ rises to the "H" level, which is a voltage above a writing voltage of the storage cell. The writing voltage is more than a supply voltage $V_{CC}$.

Thus, the column lines are communicated to the sense amplifiers. At a time $t_3$ , information is output from the storage cells coupled to the selected row line to the respective column lines, causing the differential voltages between the pairs of the column lines CL0 and $\overline{CL0}$, CL1 and $\overline{CL1}$, ---, and CL511 and $\overline{CL511}$. At this time, since the selection signal $\phi_S$ has risen enough, the differential voltages are applied to the sense amplifiers $SA_0$ , $SA_1$ , ---, and SA511, respectively without a time delay. In this case, since the selection signal $\phi_S$ is the "H" level, pairs of the even number column lines are communicated with the even number sense amplifiers, and pairs of the odd number column lines are communicated with the odd number sense amplifiers. For instance, the pair of column lines CL0 and $\overline{CL0}$ is communicated with the sense amplifier SA0, and the pair of column lines CL1 and $\overline{CL1}$ is communicated with the

sense amplifier SA1.

At a time $t_4$ , the sense amplifiers start to amplify the applied differential voltages. Thus, the nodes N0, $\overline{N0}$, N1, $\overline{N1}$ are charged or discharged to $V_{CC}$ or/ to a voltage $V_{SS}$. For instance, as shown in Fig. 3b, the nodes N0 and N1 are charged to $V_{CC}$ and the nodes $\overline{N0}$ and $\overline{N1}$ are discharged to $V_{SS}$. These amplified voltages are written to the storage cells via the respective column lines. Thus, the refresh operation of the storage cells is achieved. It should be noted that, in this case ($\phi_S$ = "H"), the storage cells communicated with the column lines CL0 and $\overline{CL0}$ are refreshed by the sense amplifier SA0, and the storage cells communicated with the column lines CL1 and $\overline{CL1}$ are refreshed by the sense amplifier SA1 which is exclusively used for a refreshing operation. At the time $t_4$ , furthermore, the column addresses $A_0\overline{A}_0$ to $A_7\overline{A}_7$ are given. Thus, one of the information developed at the nodes N0, $\overline{N0}$, N2, $\overline{N2}$, ---, N510, and $\overline{N510}$ is selected. The selected information is fed to the data bus 28 at a time $t_5$.

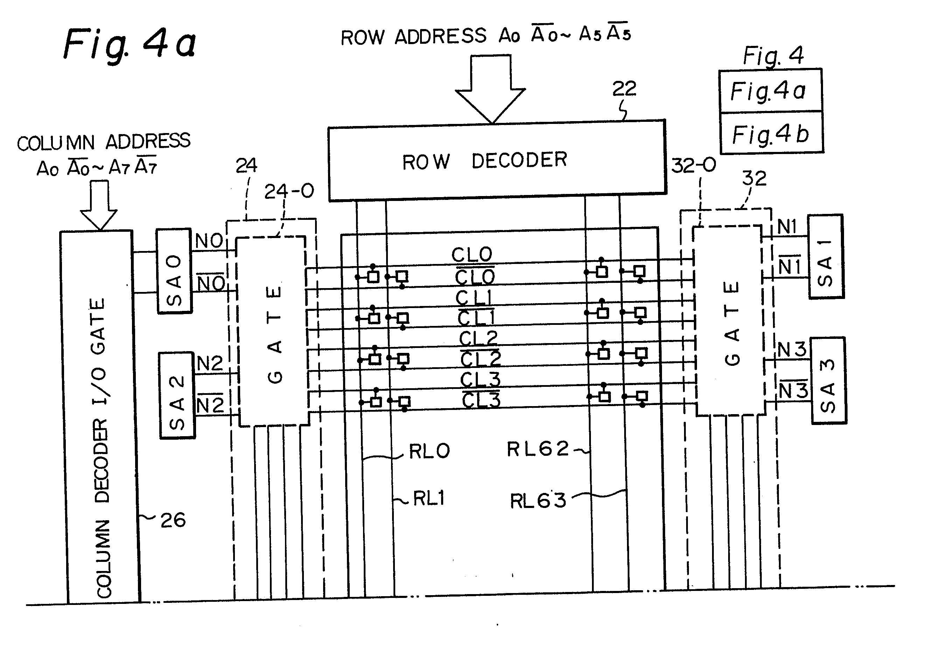

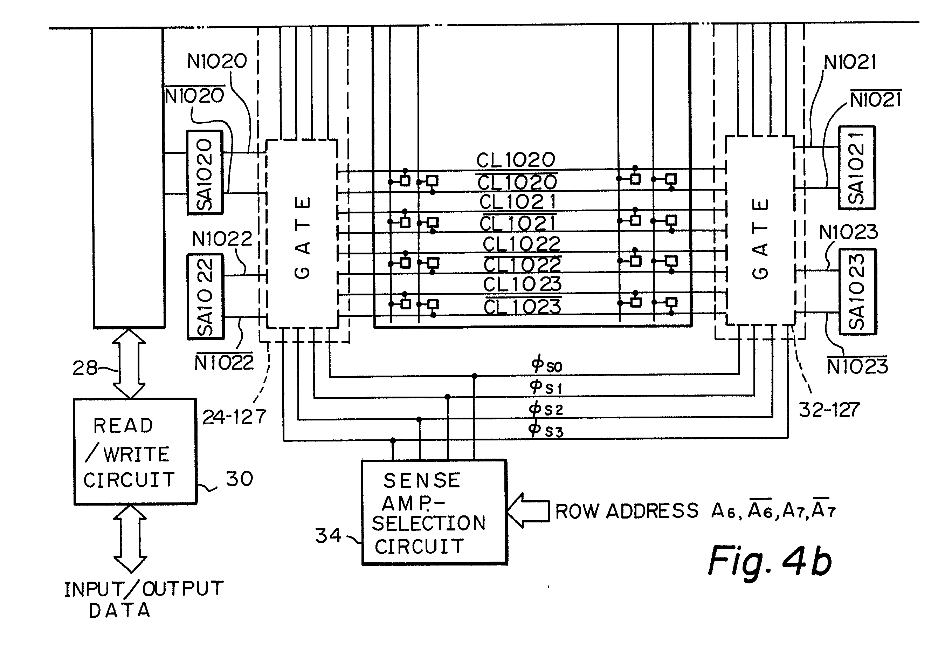

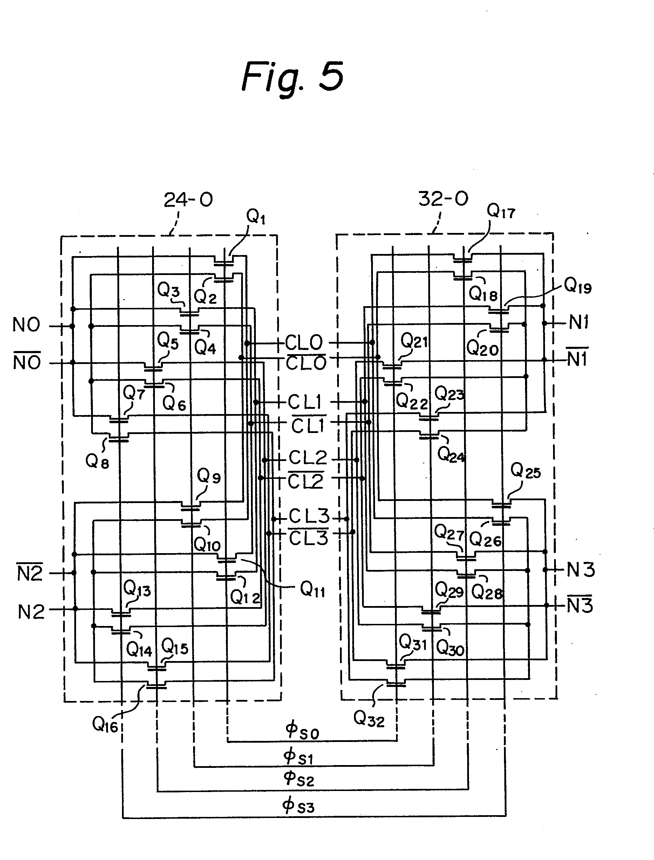

Figure 4 (Figs. 4a and 4b) illustrates another embodiment of the present invention, and Fig. 5 illustrates in detail a part of the gate circuits in the embodiment of Fig. 4.

In this embodiment, the storage cell array is coupled to 64 row lines and to 1024 column lines. One quarter of the 1024 sense amplifiers are connected to a column decoder and I/O gate circuit 26. The remaining sense amplifiers are exclusively used for refreshihg. For instance, a sense amplifier SA0 is connected to the column decoder and I/O gate circuit 26, but sense amplifiers SA1, SA2, and SA3 are not connected to the column decoder. Therefore, one of the pairs of the column lines CL0 and $\overline{CL0}$, CL1 and $\overline{CL1}$, CL2 and $\overline{CL2}$, and CL3 and $\overline{CL3}$ is communicated to the sense amplifier SA0 and thus communicated to the column decoder. The other pairs of the column lines are communicated to the sense amplifiers SA1, SA2, and SA3 to execute only the refresh operation. This selection of pairs of the column lines is executed by gate circuits 24 and 32 shown in detail in Fig. 5. The gate circuits 24 and 32 are controlled by four selection signals $\phi_{S0}$ to $\phi_{S3}$ from a sense amplifier selection circuit 34. The sense amplifier selection circuit 34 produces the selection signal $\phi_{S0}$ to $\phi_{S3}$ in response to the lower two bits $A_6\bar{A}_6$ and $A_7\bar{A}_7$ of the row address.

Since the operation of this latter embodiment is similar to the former embodiment, a detailed explanation of the operation is omitted.

Many widely different embodiments of the present invention may be constructed without departing from the spirit and scope of the present invention. It should be understood that the present invention is not limited to the specific embodiments described in this specification, except as defined in the appended claims.

0107387

Claims:

1.      A semiconductor memory device comprising:

a plurality of row lines;

a plurality of column lines;

a plurality of storage cells coupled to one of said row lines and to one of said column lines;

a plurality of gate means, one end of said gate means being connected to both ends of said column lines;

a plurality of sense amplifiers disposed along both ends of said column lines and connected to the other end of said gate means; and

a selection circuit for switching said gate means in response to at least one selection signal, so that a part of said column lines communicate via said gate means with a part of said sense amplifiers to read out information stored in the communicated storage cells or to write in new information to the communicated storage cells, and the remaining column lines communicate via said gate means with the remaining sense amplifiers to execute only the refresh operation of the storage cells coupled to the remaining column lines.

2.      A semiconductor memory device comprising:

a plurality of row lines;

a plurality of pairs of column lines;

a plurality of storage cells coupled to one of said row lines and to one of said column lines;

a plurality of gate means disposed along both ends of said column lines, one end of said gate means being connected to both ends of the pair of said column lines;

a plurality of sense amplifiers disposed along both ends of said column lines and connected to the other end of said gate means;

a row decoder means disposed along and connected to one end of said row lines;

a column decoder means disposed along one end of said column lines and connected to a part of said sense amplifiers; and

a selection circuit for switching said gate means in response to at least one selection signal to select a part of the column line pairs, so that the selected pairs of column lines communicate via said gate means with said sense amplifiers connected to said column decoder means to read out information stored in the communicated storage cells to write in new information to the communicated storage cells, and the non-selected pairs of column lines communicate via said gate means with the remaining sense amplifiers to excute only the refresh operation of the storage cells coupled to the non-selected pairs of column lines.

3.      A semiconductor memory device comprising:

a plurality of row lines;

a plurality of pairs of column lines which cross said row lines;

a plurality of storage cells coupled to one of said row lines and to one of said column lines at the crossing points;

a plurality of gate means disposed along both ends of said column lines and connected to both ends of the pairs of said column lines;

a plurality of sense amplifiers disposed along both ends of said column lines, each of said sense amplifiers being coupled to two pairs of said column lines via said gate means;

a row decoder means disposed along and connected to one end of said row lines;

a column decoder means disposed along one end of said column lines and coupled to said sense amplifier disposed on the same side with respect to said column lines; and

a selection circuit for switching said gate means in response to a part of the row address information to select a part of pairs of column lines, so that the selected pairs of column lines communicate via said gate means with said sense amplifiers disposed on the same side of said column decoder to read out information stored in the communicated storage cells or to write in new information to the communicated storage cells, and the non-selected pairs of column lines communicate via said gate means with the sense amplifiers disposed on the other side to execute only the refresh operation of the communicated storage cells.

4.     A semiconductor memory device as claimed in claim 1, 2 or 3, wherein said gate means include bidirectional transfer gate elements.

5.     A semiconductor memory device as claimed in claim 4, wherein each of said bidirectional transfer gate elements is composed of a field effect transistor having a gate and source and drain regions, said gate being coupled to said selection circuit and said source and drain regions being connected between one of said column lines and one of said sense amplifiers.

6.     A semiconductor memory device as claimed in claim 5, wherein said selection circuit provided a voltage above a writing voltage of the storage cell to the gate of a part of said field effect transistors, which are selected to turn on.

7.     A semiconductor memory device as claimed in any preceding claim, wherein each of said sense amplifiers includes a bistable circuit and an active pull-up circuit which are coupled to a gate means.

8.     A semiconductor memory device as claimed in any preceding claim wherein each of said storage cells is composed of a field effect transistor and a capacitor.

9.     A semiconductor memory device as claimed in any preceding claim, wherein said selection signal is a part of the row address information.

Fig. 1

Fig. 2

0107387

2/6

Fig. 3a

Fig. 3b

3/6

0107387

*Fig. 4a*

| Fig.4 | |
|---|---|
| Fig.4a | |
| Fig.4b | |

ROW ADDRESS $A_0 \bar{A}_0 \sim A_5 \bar{A}_5$

ROW DECODER — 22

COLUMN ADDRESS $A_0 \bar{A}_0 \sim A_7 \bar{A}_7$

COLUMN DECODER I/O GATE — 26

GATE — 32, 32-0

GATE — 24, 24-0

SA1 — N1, $\overline{N1}$

SA3 — N3, $\overline{N3}$

SA0 — N0, $\overline{N0}$

SA2 — N2, $\overline{N2}$

CL0, $\overline{CL0}$, CL1, $\overline{CL1}$, CL2, $\overline{CL2}$, CL3, $\overline{CL3}$

RL0, RL1, RL62, RL63

Fig. 4b

0107387

Fig. 5